# EUROPEAN PATENT APPLICATION

(11) **EP 4 694 625 A1**
(43) Date of publication of application: **11.02.2026**
(21) Application number: 25163899.5
(22) Date of filing: 14.03.2025
(51) Int. Cl.: H10F 10/165, H10F 71/00, H10F 77/30, H10F 77/20

(54) **SOLAR CELL AND PHOTOVOLTAIC MODULE**

(30) Priority: 05.08.2024 CN 202411067068
(71) Applicant: Jinko Solar (Shangrao) Co., Ltd, Jiangxi 334100 (CN); Zhejiang Jinko Solar Co., Ltd., Haining, Zhejiang 314416 (CN)
(72) Inventor: LI, Huimin, Shangrao, 334100 (CN); XU, Menglei, Shangrao, 334100 (CN); YANG, Jie, Shangrao, 334100 (CN); ZHANG, Xinyu, Shangrao, 334100 (CN)
(74) Representative: Haseltine Lake Kempner LLP

(57) **Abstract**

Disclosed are a solar cell (100) and a photovoltaic module (10). The solar cell (100) includes: a substrate (110), a passivation contact layer (120), a doped layer (130), and a first passivation dielectric layer (140). The substrate (110) has a first surface (m1) and a second surface (m2) arranged to be opposite to each other, and the first surface (m1) of the substrate (110) includes a first region (z1) and a second region (z2) alternately arranged along a preset direction. The passivation contact layer (120) is disposed in the first region (z1) and includes a tunneling layer (121) and a doped conductive layer (122) stacked and arranged in the first region (z1) of the first surface (m1). The doped layer (130) is disposed in the second region (z2). The first passivation dielectric layer (140) is disposed on a surface of the doped layer (130) facing away from the substrate (110).

## Description

### TECHNICAL FIELD

The present application relates to the technical field of solar cells, and in particular to a solar cell and a photovoltaic module.

### BACKGROUND

Back Contact (BC) cell is a type of solar cell and has a main feature that a PN junction and a metal electrode are both arranged on the back surface of the solar cell, so that no electrode blocks the front surface of the solar cell, thereby increasing the area of the cell absorbing sunlight, improving a conversion efficiency and generating more electricity.

### SUMMARY

According to one aspect of the present application, an embodiment of the present application provides a solar cell, including: a substrate, a passivation contact layer, a doped layer and a first passivation dielectric layer.

The substrate has a first surface and a second surface arranged to be opposite to each other, and the first surface of the substrate includes a first region and a second region alternately arranged along a preset direction.

The passivation contact layer is disposed in the first region and includes a tunneling layer and a doped conductive layer stacked and arranged in the first region of the first surface.

The doped layer is disposed in the second region.

The first passivation dielectric layer is disposed on a surface of the doped layer facing away from the substrate.

In an embodiment, the first passivation dielectric layer includes at least a first doped oxide layer.

In an embodiment, a material of the first doped oxide layer includes doped silicon oxide. Dopant elements in the first doped oxide layer include P-type dopant elements, or the dopant elements in the first doped oxide layer include P-type dopant elements and N-type dopant elements.

In an embodiment, the dopant elements in the first doped oxide layer include the P-type dopant elements, and the dopant elements in the first doped oxide layer includes boron; or the dopant elements in the first doped oxide layer include the P-type dopant elements and the N-type dopant elements, and the dopant elements in the first doped oxide layer include boron and phosphorus.

In an embodiment, the tunneling layer and the doped conductive layer are stacked and arranged in sequence on the first region of the first surface of the substrate in a direction away from the second surface.

In an embodiment, the solar cell further includes a second passivation dielectric layer. The second passivation dielectric layer is disposed on a surface of the doped conductive layer facing away from the tunneling layer.

In an embodiment, the second passivation dielectric layer is located in the first region of the first surface of the substrate; the tunneling layer, the doped conductive layer and the second passivation dielectric layer are stacked and arranged in sequence on the first region of the first surface of the substrate in a direction away from the second surface.

In an embodiment, a thickness of the first passivation dielectric layer is greater than a thickness of the second passivation dielectric layer.

In an embodiment, the second passivation dielectric layer at least includes a second doped oxide layer.

In an embodiment, a material of the second doped oxide layer includes doped silicon oxide. Dopant elements in the second doped oxide layer include N-type dopant elements.

In an embodiment, dopant elements in the second doped oxide layer include phosphorus.

In an embodiment, the doped layer and the first surface define a separation plane; along a first direction, a dimension between a surface of the doped conductive layer facing away from the substrate and the second surface is a first dimension, and a dimension between the separation plane and the second surface is a second dimension; and the first dimension is less than or equal to the second dimension.

In an embodiment, the doped layer includes a doped diffusion layer.

In an embodiment, a thickness of the first passivation dielectric layer is less than or equal to 300 nm and greater than or equal to 50 nm.

In an embodiment, a diffusion depth of the doped layer is in a range from 1µm to 3µm, or a material of the tunneling layer is a dielectric material.

In an embodiment, the substrate has dopant elements therein, and a type of the dopant elements is N-type or P-type. Alternatively, the first surface m1 and the second surface of the substrate each are provided with a textured structure.

In an embodiment, a material of the tunneling layer is doped polysilicon.

In an embodiment, a type of a dopant element in the conductive layer is opposite to a type of a dopant element in the doped conductive layer.

According to another aspect of the present application, an embodiment of the present application provides a photovoltaic module, including: a cell string, an encapsulation layer, and a cover plate.

The encapsulation layer is configured to cover a surface of the cell string. The cover plate configured to cover a surface of the encapsulation layer away from the cell string. The cell string is formed by connecting a plurality of solar cells above.

In the above-mentioned solar cell and photovoltaic module, the solar cell at least includes the substrate, the passivation contact layer, the doped layer and the first passivation dielectric layer. The passivation contact layer is arranged in the first region of the first surface of the substrate, and the doped layer and the first passivation dielectric layer are arranged in the second region of the first surface of the substrate. On one hand, since the passivation contact layer includes the tunneling layer and the doped conductive layer, the first region can achieve a better passivation effect. On the other hand, the manufacturing steps of the doped layer are simpler and more convenient than those of the passivation contact layer, and the first passivation dielectric layer can improve the passivation effect of the second region, therefore, compared with the method of arranging the passivation contact layer in both the first region and the second region, the manufacturing steps of the solar cell of the embodiment of the present application are simpler. Compared with the method of arranging the doped layer in both the first region and the second region, the solar cell of the embodiment of the present application has a better passivation effect. Therefore, the solar cell of the embodiment of the present application not only has a certain passivation effect and thus has a relatively high conversion efficiency, but also can simplify the process steps and thus can reduce the manufacturing cost.

Additional aspects and advantages of the embodiments of the present application will be given in part in the description below, and in part will become apparent from the description below, or will be learned through the practice of the embodiments of the present application.

### BRIEF DESCRIPTION OF THE DRAWINGS

Various additional advantages and benefits will become apparent to those of ordinary skill in the art from reading the following detailed description of the embodiments. The drawings are only for the purpose of illustrating the embodiments but not to be considered as limitations on the present application. Moreover, throughout the drawings, the same reference numerals are used to denote the same parts. In the accompanying drawings:
FIG. 1 is a schematic sectional view of a solar cell according to an embodiment of the present application;
FIG. 2 is a schematic sectional view of a solar cell according to another embodiment of the present application;
FIG. 3 is a schematic sectional view of a solar cell according to yet another embodiment of the present application;
FIG. 4 is a schematic sectional view of a solar cell according to yet another embodiment of the present application;
FIG. 5 is a schematic sectional view of a solar cell according to yet another embodiment of the present application;
FIG. 6 is a schematic sectional view of a solar cell according to yet another embodiment of the present application;
FIG. 7 is a schematic sectional view of a solar cell according to yet another embodiment of the present application;
FIG. 8 is a schematic view showing a structure of a photovoltaic module according to an embodiment of the present application.

Description of reference numerals:
solar cell 100;
substrate 110, first surface m1, second surface m2, first region z1, second region z2;
passivation contact layer 120, tunneling layer 121, doped conductive layer 122;
doped layer 130, separation plane *s*;
first passivation dielectric layer 140, first doped oxide layer 141;
second passivation dielectric layer 150, second doped oxide layer 151;
first anti-reflection layer 160;
first electrode 170a, second electrode 170b;
passivation film layer 180;
second anti-reflection layer 190;
isolation structure G;
photovoltaic module 10, cell string 11, encapsulation layer 12, cover plate 13, conductive tape 14;
first dimension h1, second dimension h2, first thickness d1, second thickness d2;
first direction F1, second direction F2, third direction F3.

### DETAILED DESCRIPTION OF THE EMBODIMENTS

In order to make the above objectives, features and advantages of the present application clearer and better understood, specific implementations of the present application are described in detail hereinafter with reference to the accompanying drawings. In the following description, many specific details are set forth to make the present application to be fully understood. However, the present application can be implemented in many other ways different from those described herein, and those skilled in the art can make similar improvements without departing from the connotation of the present application. Therefore, the present application is not limited by the specific embodiments disclosed below.

In the description of the present application, it should be understood that if the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. are described, the orientation or position relationships indicated by these terms are based on the orientation or position relationships shown in the accompanying drawings and are merely intended to facilitate the description of the present application and simplify the description, rather than indicating or implying that the indicated device or element must have a particular orientation or be constructed and operated in a particular orientation, and therefore are not to be interpreted as limitations on the present application.

In addition, if the terms "first" and "second" are described, these terms are used for descriptive purposes only but cannot be interpreted as indicating or implying relative importance or implicitly specifying the number of indicated technical features. Thus, the features defined as "first" and "second" may explicitly or implicitly include at least one of these features. In the description of the present application, if the term "plurality" is described, the "plurality" means at least two, such as two, and three, etc., unless otherwise clearly and specifically defined.

In the present application, unless otherwise clearly specified and limited, if the terms "mount", "connection", "communication", "fix", etc., are described, these terms should be understood in a broad sense, for example, may be a fixed connection or a detachable connection, or an integrated connection; or may be a mechanical connection or an electrical connection; or may be a direct connection or an indirect connection through an intermediate medium; or may be an internal communication between two elements or an interaction relationship between two elements, unless otherwise clearly defined. It is worth noting that, in the following description and the appended claims, one feature being electrically connected to another feature not only includes one feature being in direct contact with another feature to form an electric energy transmission or a current transmission channel, but also includes the case that there is an intermediate feature between the one feature and the other feature, and an electric energy transmission channel or a current transmission channel is formed by the one feature, the other feature, and the intermediate feature therebetween to achieve an electric energy transmission or delivery. Those of ordinary skill in the art can understand the specific meanings of the above terms in the present application according to specific situations.

In the present application, unless otherwise clearly specified and limited, if there is a description that a first feature is "above" or "under" a second feature, etc., or similar description, it may mean that the first and second features are in direct contact, or the first and second features are in indirect contact through an intermediate medium. Moreover, the first feature being "on top of", "above" and "over" the second feature may mean that the first feature is directly above or obliquely above the second feature, or simply means that the horizontal height of the first feature is greater than that of the second feature. The first feature being "under", "beneath" and "below" the second feature may mean that the first feature is directly below or obliquely below the second feature, or simply means that the horizontal height of the first feature is less than the second feature.

In the related art, improving the efficiency of back contact (BC) cells often causes the manufacturing cost thereof to be too high. In view of this, it is necessary to provide a solar cell and a photovoltaic module to reduce the manufacturing cost while improving the conversion efficiency of the solar cell.

It should be noted that when an element is referred to as being "fixed on" or "disposed on" another element, the element may be directly on the other element, or there may be an intermediate element therebetween. When the element is referred to as being "connected to" another element, the element may be directly connected to the other element, or intermediate elements may also be provided. If present, the terms "vertical", "horizontal", "upper", "lower", "left", "right" and similar expressions used in this application are for the purpose of illustration only but are not meant to be the unique embodiment.

A solar cell and a photovoltaic module according to an embodiment of the present application are described hereinafter with reference to the accompanying drawings.

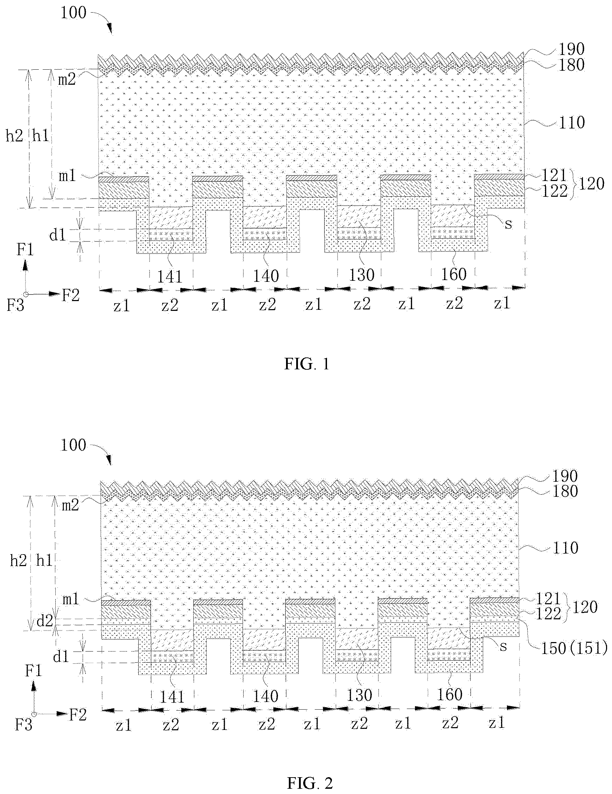

FIG. 1 shows a schematic sectional view of a solar cell 100 according to an embodiment of the present application. For ease of description, only contents related to the embodiments of the present application are shown. In the embodiments of the present application, for ease of description, the solar cell 100 is explained by taking a back contact (BC) solar cell 100 as an example for description.

Referring to FIG. 1, an embodiment of the present application provides a solar cell 100, including a substrate 110, a passivation contact layer 120, a doped layer 130, and a first passivation dielectric layer 140. In an embodiment of the present application, a first direction F1 is a thickness direction of the substrate 110, a second direction F2 and a third direction F3 may be a length direction and a width direction of the substrate 110, respectively. The first direction F1, the second direction F2, and the third direction F3 are perpendicular to each other. A dimension of the substrate 110 along the length direction may be greater than or equal to a dimension in the width direction, namely the length of the substrate 110 may be greater than or equal to the width thereof, which is not specifically limited herein.

The substrate 110 has dopant elements therein, and the type of the dopant elements is N-type or P-type. The N-type elements may be V-group elements such as phosphorus (P), bismuth (Bi), stibium (Sb), or arsenic (As), and the P-type elements may be III-group elements such as boron (B), aluminum (Al), gallium (Ga), or indium (In). For example, when the substrate 110 is a P-type substrate, the type of the dopant elements therein is P-type. For another example, when the substrate 110 is an N-type substrate, the type of the dopant elements therein is N-type.

Exemplarily, the thickness of the substrate 110 may be in a range from 100 µm to 240 µm. For example, the thickness of the substrate 110 may be 100 µm, 110 µm, 130 µm, 150 µm, 170 µm, 190 µm, 200 µm, or 240 µm. The thickness may be selected according to a specific usage and is not specifically limited herein.

The substrate 110 has a first surface m1 and a second surface m2 that are arranged to be opposite to each other. The first surface m1 and the second surface m2 are arranged to be opposite to each other along the first direction F1. Both the first surface m1 and the second surface m2 may be configured to receive incident lights. In an embodiment of the present application, the first surface m1 of the substrate 110 is a back surface, and the second surface m2 of the substrate 110 is a light-receiving surface. The light-receiving surface and the back surface are relative. The light-receiving surface is specifically the surface of the solar cell 100 or the surface of the substrate 110 in the photovoltaic module, on which sunlight mainly irradiates. With the technology development of the solar cell 100, the back surface may also receive energy of sunlight, mainly from reflected or scattered light in the surrounding environments.

The first surface m1 and the second surface m2 of the substrate 110 each may be provided with a textured structure, which can increase the light absorption area and a photogenerated current, thereby improving the efficiency of the solar cell 100. In the embodiment of the present application, FIG. 1 exemplarily illustrates that the second surface m2 of the substrate 110 is provided with a textured structure. Exemplarily, a texturing process may be performed on the second surface m2 of the substrate 110 so that a textured structure is formed on the second surface m2 of the substrate 110. The textured structure may be a pyramid-shaped textured structure. The pyramid-shaped textured structure can not only reduce the reflectivity of the second surface m2 of the substrate 110, but also form a light trap, thereby enhancing the absorption effect of the substrate 110 on the incident lights and increasing the conversion efficiency of the solar cell 100. A texturing process may be selected to be performed on the second surface m2 of the substrate 110 or not according to the use requirements. A first region z1 of the first surface m1 may also be provided with a textured structure.

The first surface m1 of the substrate 110 includes a first region z1 and a second region z2 alternately arranged along a preset direction. It may be understood that the preset direction is relative to the first surface m1. When the first surface m1 is substantially planar, the preset direction is substantially parallel to the first surface m1.

In the embodiment of the present application, FIG. 1 exemplarily illustrates the situation where the preset direction is the second direction F2. The alternating arrangement of the first region z1 and the second region z2 along the preset direction means that the regions adjacent to the first region z1 are all the second regions z2, and that the regions adjacent to the second region z2 are all the first regions z1. For example, in the case where there are multiple first regions z1 and second regions z2, referring to FIG. 1, the multiple first regions z1 and second regions z2 may be arranged alternately along the second direction F2 in the order of the first region z1, the second region z2, the first region z1, the second region z2, the first region z1, etc., or may be arranged alternately along the second direction F2 in the order of the second region z2, the first region z1, the second region z2, the first region z1, the second region z2, etc., which are not limited herein specifically. For another example, in the case where there are two first regions z1 and one second region z2, they can be arranged alternately along the second direction F2 in the order of the first region z1, the second region z2, and then the first region z1. The first region z1 and the second region z2 are arranged according to the specific usage, which is not limited specifically herein. In addition, dimensions of the first region z1 and second region z2 along the preset direction may also be set according to actual usage requirements and are not specifically limited herein.

The passivation contact layer 120 is disposed in the first region z1. In an embodiment of the present application, the passivation contact layer 120 is located in the first region z1 of the back surface of the substrate 110. The passivation contact layer 120 may reduce recombination of carriers on the surface of the substrate 110, thereby increasing an open-circuit voltage of the solar cell 100 and improving the photoelectric conversion efficiency of the solar cell 100. The passivation contact layer 120 may include a tunneling layer 121 and a doped conductive layer 122. Specifically, the passivation contact layer 120 includes the tunneling layer 121 and the doped conductive layer 122 stacked and arranged in the first region z1 of the first surface m1. That is, the tunneling layer 121 and the doped conductive layer 122 are stacked and arranged in sequence on the first region z1 of the first surface m1 of the substrate 110 in a direction away from the second surface m2.

The tunneling layer 121 is configured to achieve interface passivation of the first region z1 of the first surface m1 of the substrate 110, and achieves the effect of chemical passivation. Specifically, by saturating dangling bonds in the first region z1 of the first surface m1, an interface trap state density in the first region z1 of the first surface m1 is reduced, thereby reducing the recombination centers in the first region z1 of the first surface m1 to reduce the recombination rate of the carriers. The material of the tunneling layer 121 may be a dielectric material, for example, at least one of silicon oxide, amorphous silicon, polycrystalline silicon, silicon carbide, silicon nitride, silicon oxynitride, aluminum oxide or titanium oxide. The material of the doped conductive layer 122 may be doped polysilicon, or doped polysilicon containing at least one element of oxygen, carbon, or nitrogen. The type of the dopant element in the doped conductive layer 122 may be the same as or opposite to the type of the dopant element in the substrate 110. In embodiments of the present application, the tunneling layer 121 can be formed by low pressure chemical vapor deposition (LPCVD). Alternatively, the tunnel layer 121 may also be manufactured by other processes such as thermal oxidation process, plasma oxidation process or nitric acid oxidation process, which is not specifically limited herein.

Exemplarily, the thickness of the tunnel layer 121 may be in a range from 0.1 nm to 5 nm. For example, the thickness of the tunnel layer 121 may be 0.1 nm, 0.3 nm, 0.5 nm, 1 nm, 2 nm, 3 nm, 4 nm or 5 nm. The thickness may be selected according to the specific usage and is not specifically limited herein. By controlling the thickness of the tunnel layer 121, a decrease of the fill factor caused by contact resistance can be suppressed while ensuring a certain passivation effect.

Exemplarily, the material of the doped conductive layer 122 may be phosphorus-doped polysilicon. The thickness of the doped conductive layer 122 may be in a range from 100 nm to 300 nm. For example, the thickness of the doped conductive layer 122 may be 100 nm, 120 nm, 150 nm, 180 nm, 200 nm, 230 nm or 300 nm. The thickness may be selected according to the specific usage and is not specifically limited herein.

The doped layer 130 is disposed in the second region z2. In an embodiment of the present application, the doped layer 130 is disposed in the second region z2 of the back surface of the substrate 110. The type of the dopant element in the doped layer 130 is opposite to the type of the dopant element in the doped conductive layer 122. Exemplarily, the type of the dopant element in the doped layer 130 is P-type, the type of the dopant element in the doped conductive layer 122 is N-type, and the type of the dopant element in the substrate 110 may be P-type or N-type.

The first passivation dielectric layer 140 is disposed on a surface of the doped layer 130 away from the substrate 110. The first passivation dielectric layer 140 is located in the second region z2 of the first surface m1 of the substrate 110. That is, the doped layer 130 and the first passivation dielectric layer 140 are stacked and arranged in sequence on the second region z2 of the first surface m1 of the substrate 110 in a direction away from the second surface m2. The first passivation dielectric layer 140 is configured to achieve passivation of the second region z2 of the first surface m1 of the substrate 110. The material of the first passivation dielectric layer 140 may include a single layer or a lamination of one or more of a silicon oxide layer, an aluminum oxide layer, a gallium oxide layer, a titanium oxide layer, a silicon oxynitride layer, an aluminum oxynitride layer, and a silicon carbide layer. When the material of each layer in the lamination is different, the first passivation dielectric layer 140 can achieve a good passivation effect through cooperation of multiple layers.

In the embodiment of the present application, the passivation contact layer 120 is arranged in the first region z1 of the first surface m1 of the substrate 110, and the doped layer 130 and the first passivation dielectric layer 140 are arranged in the second region z2 of the first surface m1 of the substrate 110. On one hand, since the passivation contact layer 120 includes the tunneling layer 121 and the doped conductive layer 122, the first region z1 can achieve a better passivation effect. On the other hand, the manufacturing steps of the doped layer 130 are simpler and more convenient than those of the passivation contact layer 120, and the first passivation dielectric layer 140 can improve the passivation effect of the second region z2, therefore, compared with the method of arranging the passivation contact layer 120 in both the first region z1 and the second region z2, the manufacturing steps of the solar cell 100 of the embodiment of the present application are simpler. Compared with the method of arranging the doped layer 130 in both the first region z1 and the second region z2, the solar cell 100 of the embodiment of the present application has a better passivation effect. Therefore, the solar cell 100 of the embodiment of the present application not only has a certain passivation effect and thus has a relatively high conversion efficiency, but also can simplify the process steps and thus can reduce the manufacturing cost.

In some embodiments, continue to refer to FIG. 1, the first passivation dielectric layer 140 includes at least a first doped oxide layer 141. That is, when the first passivation dielectric layer 140 is a single-layer structure, the first passivation dielectric layer 140 is a first doped oxide layer 141. When the first passivation dielectric layer 140 is a multi-layer structure, the first passivation dielectric layer 140 includes other passivation dielectric layers capable of performing passivation in addition to the first doped oxide layer 141. FIG. 1 exemplarily illustrates that the first passivation dielectric layer 140 is a single-layer structure and the first passivation dielectric layer 140 is the first doped oxide layer 141.

The type of the dopant element in the first doped oxide layer 141 may be the same as or different from the type of the dopant element in the doped layer 130. Exemplarily, the type of the dopant element in the first doped oxide layer 141 and the type of the dopant element in the doped layer 130 are both P-type. The oxide in the first doped oxide layer 141 may be silicon oxide, or other materials which are not specifically limited herein.

In this way, the first doped oxide layer 141 is arranged not only for passivation, but also for controlling diffusion characteristics of metal paste when corresponding electrodes are formed in the second region z2 of the first surface m1 by screen printing the metal paste, which is illustrated hereinafter, thereby contributing to bringing the corresponding electrodes and the doped layer 130 into a contact.

In some embodiments, referring to FIG. 1, the material of the first doped oxide layer 141 includes doped silicon oxide. The dopant elements in the first doped oxide layer 141 include the P-type dopant elements. Alternatively, the dopant elements in the first doped oxide layer 141 include P-type dopant elements and N-type dopant elements.

The type of the dopant element in the first doped oxide layer 141 can be configured according to the manufacturing method of the first doped oxide layer 141 and the corresponding use requirements therefor.

Exemplarily, the doped layer 130 and an initial doped oxide layer may be formed by doping boron into the first surface m1 of the substrate 110, and in this case, the material of the initial doped oxide layer is borosilicate glass (BSG). Subsequently, the doped layer 130 and the initial doped oxide layer located in the first region z1 of the first surface m1 of the substrate 110 are removed, and then the passivation contact layer 120 is prepared. After the doped conductive layer 122 in the passivation contact layer 120 is formed, since the dopant element in the doped conductive layer 122 is an N-type dopant element (for example, phosphorus), the initial doped oxide layer is doped with the N-type dopant element, forming an intermediate doped oxide layer. For example, the material of the intermediate doped oxide layer may include borosilicate glass and boron-phosphorosilicate glass (BPSG), or may include boron-phosphorosilicate glass only. The process of forming the intermediate doped oxide layer may be controlled by the process of forming the doped conductive layer 122. For example, the process of forming the intermediate doped oxide layer may be controlled by controlling relevant parameters such as thickness, density, and doping concentration. In the case where the material of the intermediate doped oxide layer includes the borosilicate glass and the boron-phosphorosilicate glass, the boron-phosphorosilicate glass layer may be removed by a related process (e.g., an etching process) to form the first doped oxide layer 141. Alternatively, the boron-phosphorosilicate glass layer may remain, and the intermediate doped oxide layer may function as the first doped oxide layer 141. That is, the material of the first doped oxide layer 141 may be the borosilicate glass, or the borosilicate glass and the boron-phosphorosilicate glass, or the boron-phosphorosilicate glass, which is not specifically limited herein, and the required first doped oxide layer 141 may be configured according to the specific usage.

After the passivation contact layer 120 is formed entirely on the first surface, the passivation contact layer 120, formed on side walls of the doped layer 130 and on the surface and side walls of the first passivation dielectric layer 140, and a layer (for example, the phospho-silicate glass (PSG) layer illustrated hereinafter) formed when the doped conductive layer 122 is formed, may be removed again by patterning technology.

In this way, the material of the first doped oxide layer 141 may be selected flexibly according to the use requirements. Further, the first doped oxide layer 141 may be formed by means of the process of doping the first surface m1 of the substrate 110 with a P-type dopant element to form the doped layer 130. Alternatively, the first doped oxide layer 141 may be further formed by means of the process of making the passivation contact layer 120. In this way, the first doped oxide layer 141 may be formed by means of the process of forming each layer in the solar cell 100, which further simplifies the process and further reduces the production cost.

In addition, in the process of forming the first doped oxide layer 141 by means of doping the first surface m1 of the substrate 110 with the P-type dopant element to form the doped layer 130, and in the process of forming the doped conductive layer 122, the first doped oxide layer 141 may block the dopant element (for example, phosphorus) used to form the doped conductive layer 122 from entering the doped layer 130. In this way, the influence on the doped layer 130 can be reduced, which is beneficial to the formation of the PN junction of the solar cell 100, thereby improving the conversion efficiency of the cell.

The first doped oxide layer 141 may also be doped with other P-type dopant elements. Alternatively, when the substrate 110 is a P-type substrate, the first doped oxide layer 141 may be formed by means of the doping process of the substrate 110 itself. In this case, the passivation of the second region z2 may be achieved by providing the passivation dielectric layer additionally. For example, the material of the passivation dielectric layer may include aluminum oxide and silicon nitride, which is not specifically limited herein.

In some embodiments, continue to refer to FIG. 1, the dopant elements in the first doped oxide layer 141 include P-type dopant elements, for example, the dopant elements in the first doped oxide layer 141 include boron. Alternatively, the dopant elements in the first doped oxide layer 141 include P-type dopant elements and N-type dopant elements, for example, the dopant elements in the first doped oxide layer 141 include boron and phosphorus.

In this way, the P-type dopant elements and the N-type dopant elements may be selected according to the usage and are not specifically limited herein. When the P-type dopant elements include boron and/or the N-type dopant elements include phosphorus, a certain doping effect and a certain passivation effect as well can be achieved.

FIG. 2 shows a schematic sectional view of a solar cell 100 according to another embodiment of the present application. For ease of explanation, only contents related to the embodiment of the present application are shown.

In some embodiments, referring to FIG. 2, the solar cell 100 further includes a second passivation dielectric layer 150. The second passivation dielectric layer 150 is arranged on a surface of the doped conductive layer 122 away from the tunneling layer 121.

The second passivation dielectric layer 150 is located in the first region z1 of the first surface m1 of the substrate 110. That is, the tunneling layer 121, the doped conductive layer 122 and the second passivation dielectric layer 150 are stacked and arranged in sequence on the first region z1 of the first surface m1 of the substrate 110 in a direction away from the second surface m2. The second passivation dielectric layer 150 can achieve a certain passivation effect. The material of the second passivation dielectric layer 150 may include a single layer or a lamination of one or more of a silicon oxide layer, an aluminum oxide layer, a gallium oxide layer, a titanium oxide layer, a silicon oxynitride layer, an aluminum oxynitride layer, and a silicon carbide layer. When the materials of layers in the lamination are different, the second passivation dielectric layer 150 can achieve a good passivation effect through cooperation of the layers in the lamination.

Exemplarily, the thickness of the second passivation dielectric layer 150 may be less than or equal to 30 nm. For example, the thickness of the second passivation dielectric layer 150 may be 1 nm, 2 nm, 5 nm, 9 nm, 11 nm, 15 nm, 18 nm, 20 nm, 25 nm, 28 nm or 30 nm, which may be configured according to specific usage and is not specifically limited herein.

In this way, the second passivation dielectric layer 150 is arranged, and may be used in conjunction with the passivation contact structure, thereby achieving a certain passivation effect.

In some embodiments, continue to refer to FIG. 2, the second passivation dielectric layer 150 includes at least a second doped oxide layer 151. That is, when the second passivation dielectric layer 150 is a single-layer structure, the second passivation dielectric layer 150 is a second doped oxide layer 151, and when the second passivation dielectric layer 150 is a multi-layer structure, the second passivation dielectric layer 150 includes, in addition to the second doped oxide layer 151, other passivation dielectric layers capable of performing passivation. FIG. 2 exemplarily illustrates the case where the second passivation dielectric layer 150 is a single-layer structure and the second passivation dielectric layer 150 is the second doped oxide layer 151.

The type of the dopant element in the second doped oxide layer 151 may be the same as the type of the dopant element in the doped conductive layer 122. Exemplarily, the type of the dopant element in the second doped oxide layer 151 and the type of the dopant element in the doped conductive layer 122 are both N-type. The oxide in the second doped oxide layer 151 may be silicon oxide, or any other material which is not specifically limited herein.

In this way, the second doped oxide layer 151 is arranged not only for passivation, but also for controlling the diffusion characteristics of the metal paste when forming the corresponding electrodes in the first region z1 of the first surface m1 by screen printing the metal paste, which is illustrated hereinafter, thereby contributing to bringing the corresponding electrodes and the doped conductive layer 122 into a contact.

In some embodiments, referring to FIG. 2, the material of the second doped oxide layer 151 includes doped silicon oxide. The dopant elements in the second doped oxide layer 151 include N-type dopant elements. Exemplarily, the dopant elements in the second doped oxide layer 151 include phosphorus.

The second doped oxide layer 151 may be arranged according to the manufacturing method of the first doped oxide layer 141 and the corresponding use requirements. For example, referring to the corresponding processes illustrated in some aforementioned embodiments, in the process of forming the doped conductive layer 122 in the passivation contact layer 120, taking the dopant element in the doped conductive layer 122 being phosphorus as an example, a phosphosilicate glass (PSG) layer may be formed, that is, the PSG layer may be used as the second doped oxide layer 151.

The second doped oxide layer 151 may also be doped with other N-type dopant elements which are not specifically limited herein.

In this way, the material of the second doped oxide layer 151 may be selected flexibly according to the use requirements. Further, the second doped oxide layer 151 may be formed by means of the process of forming the doped semiconductor layer. In this way, the second doped oxide layer 151 may be formed by means of the process of forming each layer in the solar cell 100, thereby further simplifying the process and further reducing the manufacturing cost. In addition, when the dopant elements in the second doped oxide layer 151 include phosphorus, a certain doping effect and a certain passivation effect as well can be achieved.

In some embodiments, continue to refer to FIG. 2, the thickness of the first passivation dielectric layer 140 is greater than the thickness of the second passivation dielectric layer 150. That is, the thickness of the first passivation dielectric layer 140 is a first thickness d1, and the thickness of the second passivation dielectric layer 150 is a second thickness d2, and the first thickness d1 is greater than the second thickness d2.

Specifically, referring to FIG. 2, taking the case where the first passivation dielectric layer 140 is the first doped oxide layer 141, the second passivation dielectric layer 150 is the second doped oxide layer 151, the material of the first doped oxide layer 141 is borosilicate glass, and the material of the second doped oxide layer 151 is phosphosilicate glass as an example, in the case where the first doped oxide layer 141 is formed by means of the process of forming the doped layer 130, the inventors of the present invention have found that phosphorus can replace silicon more easily than boron can, and the phosphorus elements in a corresponding gap are less than the boron elements in the corresponding gap, therefore a relatively long oxidation time may be taken to absorb the boron in the corresponding gap during the boron diffusion process, thereby improving the passivation effect of the first doped oxide layer 141. Moreover, the oxidation time for forming the second doped oxide layer 151 may be less than the oxidation time for forming the first doped oxide layer 141. In this process, the thickness of the first doped oxide layer 141 formed through a relatively long oxidation time is greater than the thickness of the second doped oxide layer 151 formed through a relatively short oxidation time.

Thus, on one hand, by controlling the thickness of the first passivation dielectric layer 140, the passivation effect can be further improved. And on the other hand, by controlling the thickness of the second passivation dielectric layer 150, the process time can be further saved, thereby improving the production efficiency, and reducing the manufacturing cost.

In some other embodiments, continue to refer to FIG. 1, when the second passivation dielectric layer 150 is formed in the process of forming the doped conductive layer 122, the second passivation dielectric layer 150 may also be removed, which may be configured according to the specific usage and is not specifically limited herein.

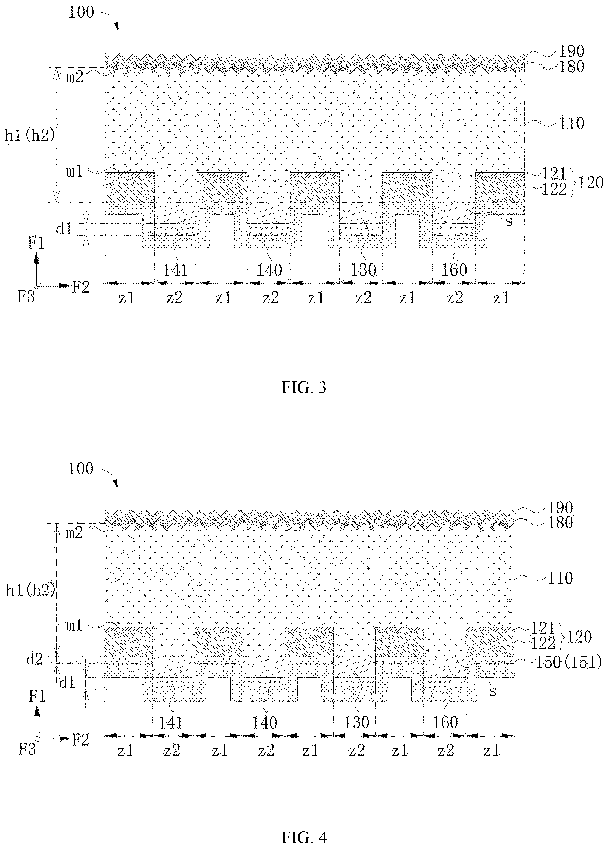

FIG. 3 shows a schematic sectional view of a solar cell 100 according to yet another embodiment of the present application. FIG. 4 shows a schematic sectional view of a solar cell 100 according to yet another embodiment of the present application. For ease of explanation, only the features related to the embodiments of the present application are shown. The structure shown in FIG. 3 is not provided with the second passivation dielectric layer 150, while the structure shown in FIG. 4 is provided with the second passivation dielectric layer 150.

In some embodiments, continue to refer to FIG. 1 and FIG. 2 in combination with FIG. 3 and FIG. 4, the doped layer 130 and the first surface m1 define a separation plane s. Along the first direction F1, a dimension between a surface of the doped conductive layer 122 facing away from the substrate 110 and the second surface m2 is a first dimension h1, and a dimension between the separation plane s and the second surface m2 is a second dimension h2. The first dimension h1 is less than or equal to the second dimension h2. FIG. 1 and FIG. 2 exemplarily illustrate the case where the first dimension h1 is less than the second dimension h2, and FIG. 3 and FIG. 4 exemplarily illustrate the case where the first dimension h1 is equal to the second dimension h2.

Specifically, taking the case where the structure of the second region z2 of the first surface m1 of the substrate 110 is manufactured first and then the structure of the first region z1 of the first surface m1 of the substrate 110 is manufactured for an example, and referring to the manufacturing process illustrated in some aforementioned embodiments, and in the case where the doped layer 130 and the first passivation dielectric layer 140 are formed by diffusion methods such as boron diffusion, the doped layer 130 is formed on the first surface m1 through diffusing toward the second surface m2, and the doped layer 130 has a certain diffusion depth. Subsequently, the first region z1 of the first surface m1 may be processed by a patterning technology (for example, an etching process) to remove the doped layer 130 and the first passivation dielectric layer 140 located in the first region z1. In this process, the first region z1 is formed to be concave relative to the second region z2, and the dimension of the concave of the first region z1 along the first direction F1 can be approximately several microns. Then, a passivation contact layer 120 is formed in the first region z1, and the thickness of the passivation contact layer 120 is approximately 300nm. In this way, a height of the structure at the second region z2 of the first surface m1 is different from a height of the structure at the first region z1 of the first surface m1.

In this way, the first dimension h1 is controlled to be less than or equal to the second dimension h2, thus making it convenient to manufacture the passivation contact layer 120 and contributing to forming the required passivation contact layer 120 in the first region z1. In addition, when the doped layer 130 is manufactured through diffusion, since the diffusion temperature is relatively high, the influence on the manufacturing of the doped conductive layer 122 can be reduced by manufacturing the relevant structures on the second region z2 first and then manufacturing the relevant structures on the first region z1.

In some embodiments, in order to better remove the doped layer 130 on the first region z1 of the first surface m1, through controlling the etching depth, the first region z1 of the first surface m1 may also be formed to be concaved relative to the second region z2. Alternatively, the first region z1 and the second region z2 of the first surface m1 may also be aligned with each other, that is, the relative position relationship of the first region z1 and the second region z2 of the first surface m1 may be configured according to various structures on the first surface m1, and is not limited specifically herein.

In some embodiments, continue to refer to FIG. 1 to FIG. 4, the doped layer 130 includes a doping diffusion layer.

Exemplarily, a diffusion treatment may be performed on the first surface m1 of the substrate 110 in a diffusion furnace containing P-type dopant elements to form a doped diffusion layer, and then the first surface m1 of the substrate 110 is patterned to remain only the doped diffusion layer located on the second region z2 of the first surface m1 of the substrate 110. Alternatively, a mask layer may be provided to cover the first region z1 of the first surface m1, and then a diffusion treatment may be performed on the second region z2 of the first surface m1, which is not covered by the mask layer, to form doped diffusion portions separated from each other, and all the doped diffusion portions constitute the doped diffusion layer.

Exemplarily, the doped layer 130 may be a boron diffusion layer, and the diffusion depth of the doped layer 130 is in a range from 1µm to 3µm. For example, the diffusion depth of the doped layer 130 may be 1 µm, 1.2 µm, 1.5 µm, 2 µm or 3 µm, and may be configured according to the specific usage and is not specifically limited here.

In this way, the doped diffusion layer may be formed by selecting different manufacturing methods flexibly according to the use requirements, which is not limited specifically herein. In the case where the doped layer 130 includes the doped diffusion layer, the first passivation dielectric layer 140 may be manufactured by means of the process of forming the doped diffusion layer. In the case where the doped diffusion layer located in the second region z2 of the first surface m1 is formed by means of the above-mentioned patterning, manufacturing becomes easier while the doped diffusion layer with better doping effect is achieved.

In some embodiments, referring to FIGS. 1 to 4, the thickness of the first passivation dielectric layer 140 (i.e., the first thickness d1) is less than or equal to 300 nm, and greater than or equal to 50 nm. For example, the first thickness d1 is greater than or equal to 80 nm, and less than or equal to 200 nm. For example, the first thickness d1 may be 80 nm, 90 nm, 100 nm, 120 nm, 140 nm, 150 nm, 170 nm, 180 nm, 190 nm, or 200 nm.

In this way, by controlling the thickness of the first passivation dielectric layer 140, the manufacturing cost can be reduced while a certain passivation performance can be ensured.

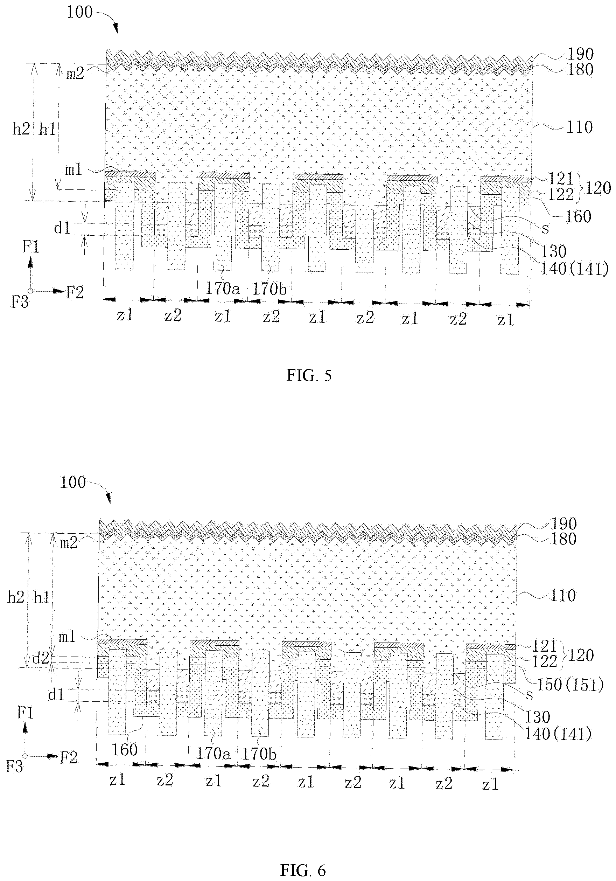

FIG. 5 shows a schematic sectional view of a solar cell 100 according to yet another embodiment of the present application, and FIG. 6 shows a schematic sectional view of a solar cell 100 according to another embodiment of the present application. For ease of explanation, only the contents related to the embodiments of the present application are shown. The structure shown in FIG. 5 is not provided with the second passivation dielectric layer 150, while the structure shown in FIG. 6 is provided with the second passivation dielectric layer 150.

In some embodiments, referring to FIG. 5 and FIG. 6, the solar cell 100 further includes a first electrode 170a located in the first region z1 and in ohmic contact with the doped layer 130, and a second electrode 170b located in the second region z2 and in ohmic contact with the doped conductive layer 122.

In some embodiments of the present application, the materials of the first electrode 170a and second electrode 170b include, but are not limited to, one or more of aluminum(Al), titanium(Ti), nickel(Ni), cobalt(Co), silver(Ag), copper(Cu), and stannum(Sn). The first electrode 170a and the second electrode 170b may be formed by screen printing, laser transfer, or electroplating. In an embodiment of the present application, the first electrode 170a and the second electrode 170b may be metal grid lines, and the width and thickness of each metal grid line is not limited.

Exemplarily, the first electrode 170a may be made of silver paste, and the second electrode 170b may be made of silver paste or silver aluminum paste. The width of the first electrode 170a may be in a range from 30 µm to 120 µm. For example, the width of the first electrode 170a may be 30 µm, 40 µm, 50 µm, 80 µm, 90 µm, 100 µm, 110 µm, or 120 µm. The width of the second electrode 170b may be in a range from 30 µm to 120 µm. For example, the width of the second electrode 170b may be 30 µm, 40 µm, 50 µm, 80 µm, 90 µm, 100 µm, 110 µm, or 120 µm, which may be set according to the specific usage and is not specifically limited herein.

In this way, the first electrode 170a and the second electrode 170b arranged on the back surface of the solar cell 100, compared with the electrodes arranged on the front surface of the solar cell 100 in the prior art, can significantly reduce the influence on the light absorption of the cell, thereby improving the light absorption of the solar cell 100.

In some embodiments, continue to refer to FIGS. 1 to 6, the solar cell 100 further includes a first anti-reflection layer 160. The first anti-reflection layer 160 is located on a surface of the passivation contact layer 120 facing away from the substrate 110 and on a surface of the doped layer 130 facing away from the substrate 110.

Exemplarily, the first anti-reflection layer 160 covers the surfaces of the doped conductive layer 122 and doped layer 130 facing away from the substrate 110. The first anti-reflection layer 160 may be a single-layer structure or a multi-layer structure. In the first anti-reflection layer 160 of the multi-layer structure, the material of each layer may be silicon oxide, silicon nitride or silicon oxynitride. The first electrode 170a and the second electrode 170b mentioned above may penetrate the first anti-reflection layer 160 to a corresponding layer and then comes into ohmic contact with the corresponding layer.

Exemplarily, the first anti-reflection layer 160 may be composed by two layers, and the materials of the two layers may be aluminum oxide and silicon nitride, respectively, or may be aluminum oxide and silicon oxynitride, respectively. The thickness of the first anti-reflection layer 160 may be in a range from 60 nm to 180 nm. For example, the thickness of the first anti-reflection layer 160 may be 60 nm, 80 nm, 100 nm, 130 nm, 150 nm, 160 nm, 170 nm or 180 nm, which may be set according to the specific usage and is not specifically limited herein.

In this way, the first anti-reflection layer 160 is located on the back surface of the solar cell 100 and has an anti-reflection effect on the back surface of the solar cell 100. Alternatively, in other embodiments, no first anti-reflection layer 160 is arranged.

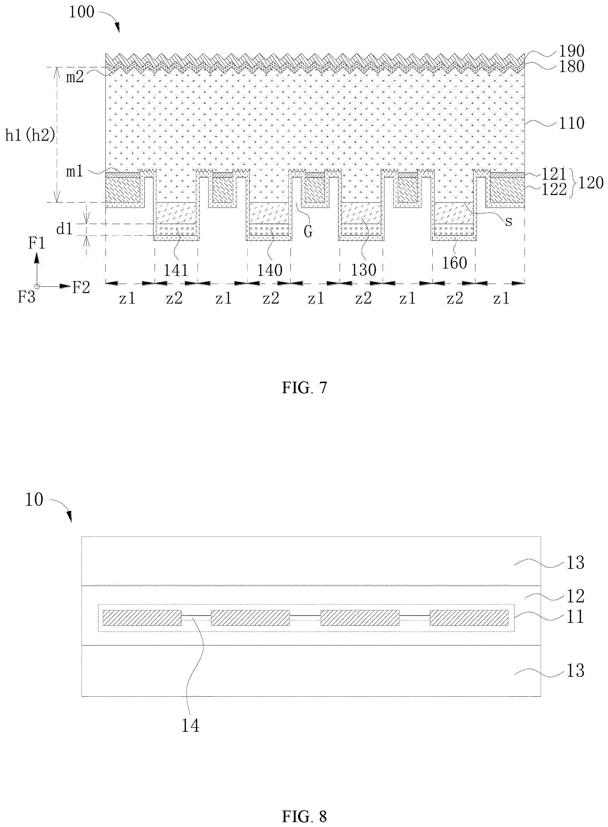

FIG. 7 shows a schematic sectional view of a solar cell 100 according to another embodiment of the present application. For ease of explanation, only the contents related to the embodiments of the present application are shown.

In some embodiments, referring to FIG. 7, the solar cell 100 further includes an isolation structure G, and the isolation structure G is located between the first region z1 and the second region z2. The isolation structure G may be a groove as shown in FIG. 7 and is formed by a patterned etching process. The isolation structure G may also be formed by an insulating dielectric layer formed by depositing an insulating dielectric. Exemplarily, a portion of the first surface m1 corresponding to the isolation structure G is constructed as a textured surface or a polished surface, and FIG. 7 illustrates the textured surface.

The isolation structure G may be located in the first region z1 of the first surface m1 and penetrate the passivation contact layer 120. The isolation structure G may also be located in the second region z2 of the first surface m1 and penetrate the doped layer 130 and extend into the substrate 110. The isolation structure G may also be located at a junction spanning the first region z1 and the second region z2.

In this way, by arranging the isolation structure G, structures with different doping types may be isolated from each other.

In some embodiments, referring to FIGS. 1 to 7, a portion of the first surface m1 located in the second region z2 is configured as a polished surface or a textured surface. FIGS. 1 to 7 exemplarily illustrate that the portion of the first surface m1 located in the second region z2 is configured as the polished surface.

In this way, the first surface m1 may be flexibly set according to usage requirements, which is not limited specifically herein.

In some embodiments, continue to refer to FIGS. 1 to 7, the solar cell 100 further includes a passivation film layer 180 arranged on the second surface m2 of the substrate 110. The passivation film layer 180 may be a single-layer structure or a multi-layer structure, and the material of the passivation film layer 180 may be at least one of aluminum oxide, silicon oxide, silicon nitride, or silicon oxynitride. In addition, the passivation film layer 180 may be formed by chemical deposition. The passivation film layer 180 plays a surface passivation role in the solar cell 100.

For example, the passivation film layer 180 may be an oxide layer, and a material thereof may be aluminum oxide. The thickness of the passivation film layer 180 may be less than or equal to 10 nm. For example, the thickness of the passivation film layer 180 may be 1 nm, 3 nm, 6 nm, 8 nm, 9 nm, or 10 nm, which may be set according to specific usage and is not specifically limited herein.

In some embodiments, continue to refer to FIGS. 1 to 7, the solar cell 100 further includes a second anti-reflection layer 190, which is disposed on a surface of the passivation film layer 180 facing away from the substrate 110. The second anti-reflection layer 190 may be a single-layer structure or a multi-layer structure. In the second anti-reflection layer 190 of the multi-layer structure, the material of each layer may be silicon oxide, silicon nitride, or silicon oxynitride.

Exemplarily, the second anti-reflection layer 190 may be a two-layer structure, and the materials of the two layers may be silicon nitride and silicon oxynitride, respectively. The thickness of the second anti-reflection layer 190 may be in a range from 60 nm to 120 nm. For example, the thickness of the second anti-reflection layer 190 may be 60 nm, 65 nm, 70 nm, 80 nm, 90 nm, 100 nm or 120 nm, which may be set according to the specific usage and is not specifically limited herein.

A specific example is provided hereinafter to illustrate a method for manufacturing a solar cell. With reference to FIG. 5, the method includes the following steps.

In Step S1, a substrate 110 is provided. The substrate 110 has a first surface m1 and a second surface m2 which are arranged opposite to each other. The first surface m1 is a back surface, and the second surface m2 is a light-receiving surface. The first surface m1 of the substrate 110 includes a first region z1 and a second region z2 which are alternately arranged along a second direction F2, and the substrate 110 is an N-type substrate.

In Step S2, an initial doped layer and an initial first passivation dielectric layer are formed on the first surface m1 of the substrate 110 by a boron diffusion process. The dopant element in the initial doped layer is boron, and the material of the initial first passivation dielectric layer is BSG.

In Step S3, one portion of the initial doped layer and one portion of the initial first passivation dielectric layer, which are located in the first region z1 of the first surface m1, are removed by a patterning process, and another portion of the initial doped layer and another portion of the initial first passivation dielectric layer, which are located in the second region z2, form the doped layer 130 and the first passivation dielectric layer 140, respectively. The first region z1 is concaved relative to the second region z2.

In Step S4, an initial tunneling layer, an initial doped conductive layer, and a PSG layer are formed in sequence on the first surface m1 of the substrate 110. The dopant element in the initial doped conductive layer is phosphorus.

In Step S5, portions of the initial tunneling layer, initial doped conductive layer and PSG layer, which are located in the second region z2, and the other portion of the PSG layer located in the first region z1 are removed by a patterning process, and the other portions of the initial tunneling layer and initial doped conductive layer, which are located in the first region z1, form a tunneling layer 121 and a doped conductive layer 122.

In Step S6, a first anti-reflection layer 160 is formed on a surface of the first passivation dielectric layer 140 facing away from the doped layer 130 and a surface of the doped conductive layer 122 facing away from the tunneling layer 121.

In Step S7, a first electrode 170a is formed in the first region z1 and a second electrode 170b is formed in the second region z2 by a metallization process, the first electrode 170a forms an ohmic contact with the doped conductive layer 122, and the second electrode 170b forms an ohmic contact with the doped layer 130.

In Step S8, a passivation film layer 180 and a second anti-reflection layer 190 are formed and stacked in sequence on the second surface m2 of the substrate 110.

Another specific example is provided hereinafter to illustrate the method for manufacturing a solar cell. With reference to FIG. 5, the method includes the following steps.

In Step S1, a substrate 110 is provided. The substrate 110 has a first surface m1 and a second surface m2 which are arranged opposite to each other, the first surface m1 is a back surface, the second surface m2 is a light-receiving surface, the first surface m1 of the substrate 110 includes a first region z1 and a second region z2 which are alternately arranged along a second direction F2, and the substrate 110 is an N-type substrate.

In Step S2, an initial doped layer and an initial first passivation dielectric layer are formed in the first surface m1 of the substrate 110 by a boron diffusion process, the dopant elements in the initial doped layer are boron, and the material of the initial first passivation dielectric layer is BSG.

In Step S3, portions of the initial doped layer and initial first passivation dielectric layer, which are located on the first region z1 of the first surface m1, are removed by a patterning process, and the doped layer 130 and the intermediate first passivation dielectric layer are formed by other portions of the initial doped layer and initial first passivation dielectric layer which are located in the second region z2, respectively. The first region z1 is concaved relative to the second region z2.

In Step S4, an initial tunneling layer, an initial doped conductive layer, and a PSG layer are formed in sequence on the first surface m1 of the substrate 110. The dopant element in the initial doped conductive layer is phosphorus, and the intermediate first passivation dielectric layer is doped with phosphorus to form a first passivation dielectric layer 140, and the material of the first passivation dielectric layer 140 includes BSG and BPSG.

In Step S5, portions of the initial tunneling layer, initial doped conductive layer and PSG layer which are located in the second region z2, and the other portion of the PSG layer located in the first region z1 are removed by a patterning process, and other portions of the initial tunneling layer and initial doped conductive layer, which are located in the first region z1, form a tunneling layer 121 and a doped conductive layer 122 respectively.

In Step S6, a first anti-reflection layer 160 is formed on a surface of the first passivation dielectric layer 140 facing away from the doped layer 130 and on a surface of the doped conductive layer 122 facing away from the tunneling layer 121.

In Step S7, a first electrode 170a is formed in the first region z1 and a second electrode 170b is formed in the second region z2 by a metallization process. The first electrode 170a forms an ohmic contact with the doped conductive layer 122, and the second electrode 170b forms an ohmic contact with the doped layer 130.

In Step S8, a passivation film layer 180 and a second anti-reflection layer 190 are stacked and formed in sequence on the second surface m2 of the substrate 110.

Thus, the corresponding solar cell can be manufactured by manufacturing the various layer structures in the solar cell illustrated in the above embodiments. The above manufacturing method is only for illustration, and other manufacturing methods can be used, and are not specifically limited herein.

Some steps or stages illustrated above are not necessarily executed at the same time, but may be executed at different times, and the execution order of these steps or stages is not necessarily sequential, but may be executed in turn or alternately with other steps or at least part of the steps or stages in other steps, which may be selected according to specific usage requirements and is not specifically limited herein.

FIG. 8 is a schematic view showing a structure of a photovoltaic module according to an embodiment of the present application, and for ease of explanation, only the contents related to the embodiment of the present application are shown.

Based on the same inventive concept, please refer to FIG. 8, an embodiment of the present application provides a photovoltaic module 10, including a cell string 11, an encapsulation layer 12 and a cover plate 13. The encapsulation layer 12 is configured to cover the surface of the cell string 11. The cover plate 13 is configured to cover the surface of the encapsulation layer 12 away from the cell string 11. The cell string 11 is formed by connecting the solar cells in any of the above embodiments. Furthermore, the solar cells are electrically connected in the form of a whole piece or multiple pieces to form a plurality of cell strings 11, and the plurality of cell strings 11 are electrically connected in series and/or in parallel.

In some embodiments, the plurality of cell strings 11 may be electrically connected via conductive tapes 14. The encapsulation layer 12 covers the front and back sides of the solar cell.

In some embodiments, the encapsulation layer 12 may be an organic encapsulation film such as an ethylene-vinyl acetate (EVA) copolymer film, a poly olefin elastomer (POE) film, or a polyethylene glycol terephthalate (PET) film.

In some embodiments, the cover plate 13 may be a glass cover plate, a plastic cover plate or other light-transmitting cover plate.

In some embodiments, the surface of the cover plate 13 facing the encapsulation layer 12 may be a concave-convex surface, thereby increasing the utilization rate of the incident lights.

The photovoltaic module 10 also has the advantages of the above solar cell, which will not be described repeatedly herein.

## Claims

1. A solar cell (100), comprising:
a substrate (110) having a first surface (m1) and a second surface (m2) arranged to be opposite to each other, the first surface (m1) of the substrate (110) comprising a first region (z1) and a second region (z2) alternately arranged along a preset direction;
a passivation contact layer (120) disposed in the first region (z1), and comprising a tunneling layer (121) and a doped conductive layer (122) stacked and arranged in the first region (z1) of the first surface (m1);
a doped layer (130) disposed in the second region (z2); and
a first passivation dielectric layer (140) disposed on a surface of the doped layer (130) facing away from the substrate (110).

2. The solar cell (100) according to claim 1, wherein the first passivation dielectric layer ()140 comprises at least a first doped oxide layer (141).

3. The solar cell according to claim 2, wherein a material of the first doped oxide layer (141) comprises doped silicon oxide;
dopant elements in the first doped oxide layer (141) comprise P-type dopant elements; or
the dopant elements in the first doped oxide layer (141) comprise P-type dopant elements and N-type dopant elements.

4. The solar cell according to claim 3, wherein the dopant elements in the first doped oxide layer (141) comprises the P-type dopant elements, and the dopant elements in the first doped oxide layer (141) comprises boron; or
the dopant elements in the first doped oxide layer (141) comprise the P-type dopant elements and the N-type dopant elements, and the dopant elements in the first doped oxide layer (141) comprise boron and phosphorus.

5. The solar cell according to any one of claims 1 to 4, wherein the tunneling layer (121) and the doped conductive layer (122) are stacked and arranged in sequence on the first region (z1) of the first surface (m1) of the substrate (110) in a direction away from the second surface (m2).

6. The solar cell according to any one of claims 1 to 5, further comprising a second passivation dielectric layer (150) disposed on a surface of the doped conductive layer (122) facing away from the tunneling layer (121).

7. The solar cell according to claim 6, wherein the second passivation dielectric layer (150) is located in the first region (z1) of the first surface (m1) of the substrate (110);
the tunneling layer (121), the doped conductive layer (122) and the second passivation dielectric layer (150) are stacked and arranged in sequence on the first region (z1) of the first surface (m1) of the substrate (110) in a direction away from the second surface (m2).

8. The solar cell according to claim 6, wherein a thickness of the first passivation dielectric layer (140) is greater than a thickness of the second passivation dielectric layer (150).

9. The solar cell according to claim 6, wherein the second passivation dielectric layer (150) at least comprises a second doped oxide layer (151);
optionally, a material of the second doped oxide layer (151) comprises doped silicon oxide, and dopant elements in the second doped oxide layer (151) comprise N-type dopant elements.

10. The solar cell according to any one of claims 1 to 9, wherein the doped layer (130) and the first surface (m1) define a separation plane (*s*); along a first direction (F1), a dimension between a surface of the doped conductive layer (122) facing away from the substrate (110) and the second surface (m2) is a first dimension (h1), and a dimension between the separation plane (s) and the second surface (m2) is a second dimension (h2); and the first dimension (h1) is less than or equal to the second dimension (h2);
optionally, the doped layer (130) comprises a doped diffusion layer.

11. The solar cell according to any one of claims 1 to 10, wherein a thickness of the first passivation dielectric layer (140) is less than or equal to 300 nm and greater than or equal to 50 nm.

12. The solar cell according to any one of claims 1 to 11, wherein a diffusion depth of the doped layer (130) is in a range from 1µm to 3µm; or
wherein a material of the tunneling layer (121) is a dielectric material.

13. The solar cell according to any one of claims 1 to 12, wherein the substrate (110) has dopant elements therein, and a type of the dopant elements is N-type or P-type; or
the first surface m1 and the second surface of the substrate each are provided with a textured structure.

14. The solar cell according to any one of claims 1 to 13, wherein a material of the doped conductive layer (122) is doped polysilicon.
optionally, a type of a dopant element in the conductive layer (122) is opposite to a type of a dopant element in the doped conductive layer (122).

15. A photovoltaic module (10), comprising:
a cell string (11);
an encapsulation layer (12) configured to cover a surface of the cell string (11); and
a cover plate (13) configured to cover a surface of the encapsulation layer (12) away from the cell string (11);
wherein the cell string (11) is formed by connecting a plurality of solar cells (100) according to any one of claims 1 to 14.
